# EUROPEAN PATENT APPLICATION

(11) **EP 3 588 564 A1**
(43) Date of publication of application: **01.01.2020**
(21) Application number: 17898006.6
(22) Date of filing: 21.02.2017
(51) Int. Cl.: H01L 27/14, H01L 31/0232, H04N 5/369

(54) **SOLID-STATE PHOTODETECTOR**

(71) Applicant: Shimadzu Corporation, Kyoto 604-8511 (JP)
(72) Inventor: KARASAWA, Tomohiro, Kyoto-shi Kyoto 604-8511 (JP); FURUMIYA, Tetsuo, Kyoto-shi Kyoto 604-8511 (JP); MORIYA, Naoji, Kyoto-shi Kyoto 604-8511 (JP); HIROSE, Ryuta, Kyoto-shi Kyoto 604-8511 (JP)
(74) Representative: Kilian Kilian & Partner
(86) International application number: PCT/JP2017/006367
(87) International publication number: WO 2018/154627

(57) **Abstract**

This solid-state photodetector (10) includes a functional layer (13) configured to prevent either traveling directions or wave front shapes of wave fronts from being aligned or matched with each other by preventing mutual interference between the wave fronts.

## Description

### Technical Field

The present invention relates to a solid-state photodetector.

### Background Art

Conventionally, a solid-state imaging device (solid-state photodetector) including a photoelectric converter that outputs a signal in accordance with the intensity of received light has been disclosed. Such a solid-state photodetector is disclosed in U.S. Patent Application Publication No. 2010/0148289, Japanese Patent Laid-Open No. 2016-58507, and Japanese Translation of PCT International Application Publication No. 2013-518414, for example.

A front surface incidence type solid-state imaging device described in U.S. Patent Application Publication No. 2010/0148289 includes a semiconductor substrate including a photoelectric converter that outputs a signal in accordance with the intensity of received light, a light receiving surface, and readout wiring disposed on the light receiving surface. The photoelectric converter and the readout wiring are covered with a surface film, and light is incident on the photoelectric converter from the photoelectric converter surface (surface) side via the surface film.

However, in the front surface incidence type solid-state imaging device described in U.S. Patent Application Publication No. 2010/0148289, light reflected by a surface of the photoelectric converter and light incident from a different portion of a light incident surface of the surface film (a portion different from a portion on which the reflected light is incident) interfere (multiple reflection interfere) with each other, and the sensitivity disadvantageously becomes unstable.

In a back surface incidence type solid-state imaging device disclosed in Japanese Patent Laid-Open No. 2016-58507, a light shielding film provided on a surface film on the surface side of a semiconductor substrate is uneven. Thus, the phase of light reflected by the light shielding film changes due to the uneven shape, and thus the phase of the light reflected by the light shielding film and the phase of light incident on a light receiving surface (back surface) from a different portion of the semiconductor substrate can be different from each other. Consequently, interference (multiple reflection interference in the semiconductor substrate) between the light incident on the light receiving surface of a photoelectric converter and the light reflected on the light shielding film side is significantly reduced or prevented. Thus, a variation in the intensity of a signal detected by the photoelectric converter due to the light interference is significantly reduced or prevented.

In a back surface incidence type solid-state imaging device disclosed in Japanese Translation of PCT International Application Publication No. 2013-518414, a fringe suppression layer made of a refractory metal oxide or a fluoride dielectric is provided on a light receiving surface of a photoelectric converter (the back surface of a semiconductor substrate). Thus, interference (multiple reflection interference in the semiconductor substrate) between light incident on the light receiving surface of the photoelectric converter (the back surface of the semiconductor substrate) and light reflected on the surface side of the semiconductor substrate (a surface opposite to the light receiving surface) is significantly reduced or prevented by the fringe suppression layer. Consequently, a variation in the intensity of a signal detected by the photoelectric converter due to the light interference is significantly reduced or prevented.

### Prior Art

### Patent Document

Patent Document 1: U.S. Patent Application Publication No. 2010/0148289
Patent Document 2: Japanese Patent Laid-Open No. 2016-58507
Patent Document 3: Japanese Translation of PCT International Application Publication No. 2013-518414

### Summary of the Invention

### Problems to be Solved by the Invention

However, a method for significantly reducing or preventing interference according to Japanese Patent Laid-Open No. 2016-58507 and Japanese Translation of PCT International Application Publication No. 2013-518414 is a method for significantly reducing or preventing interference (multiple reflection interference in the semiconductor substrate) between the light reflected by the surface opposite to the light receiving surface via the semiconductor substrate and the light incident on the light receiving surface, and in the case of interference (multiple reflection interference) generated in the surface film provided on the surface of the photoelectric converter in the front surface incidence type solid-state imaging device, the effect of significantly reducing or preventing light interference cannot be obtained.

The present invention is intended to solve at least one of the above problems. The present invention aims to provide a solid-state photodetector capable of significantly reducing or preventing multiple reflection interference in a surface film that protects a light receiving surface.

### Means for Solving the Problems

In order to attain the aforementioned object, a solid-state photodetector according to an aspect of the present invention includes a plurality of photoelectric converters configured to output signals in accordance with an intensity of received light, a surface film arranged for protecting the photoelectric converters, and a functional layer provided on a surface of the surface film. The functional layer is configured to prevent either traveling directions or wave front shapes of a first wave front, a second wave front, and a third wave front from being aligned or matched with each other by preventing mutual interference between the first wave front, the second wave front, and the third wave front. The first wave front of plane waves of light is incident on the functional layer and then transmits from a light receiving surface into the photoelectric converters. The second wave front of the plane waves of the light is incident on the functional layer, then is reflected by the light receiving surface to generate no transmitting light into the photoelectric converters, then is reflected by a surface of the functional layer, and transmits into the photoelectric converters. The third wave front of the plane waves of the light is incident on the functional layer, then is reflected by a refractive index interface that is present in the functional layer and the surface film before the second wave front is generated, and then transmits into the photoelectric converters. The refractive index boundary does not necessarily indicate a material boundary, and even when there is a material boundary, it is not necessary to consider it as a refractive index boundary if the amplitude reflectance is substantially 0.002 or less.

As described above, the solid-state photodetector according to this aspect of the present invention includes the functional layer configured to prevent either the traveling directions or the wave front shapes of the wave fronts from being aligned or matched with each other. One of the wave fronts of the plane waves of the light is incident on the surface of the surface film, then is reflected by the refractive index interface that is present in the functional layer and the surface film, and then transmits into the photoelectric converters. The remainder of the wave fronts of the plane waves of the light is incident on the surface of the surface film, then enters the functional layer, and then transmits into the photoelectric converters without being reflected at the refractive index interface. Accordingly, mutual strengthening (or weakening) of the incident light and the reflected light generated in the surface film, which occurs in the surface film in the conventional configuration, i.e. interference, is significantly reduced or prevented. Consequently, it is possible to significantly reduce or prevent multiple reflection interference in the surface film that protects the light receiving surface. Thus, instability of the sensitivity can be significantly reduced or prevented.

In the aforementioned solid-state photodetector according to this aspect, the functional layer preferably has a refractive index substantially equal to a refractive index of the surface film, or the functional layer and the surface film are preferably made of a same material. According to this configuration, light reflection at the interface between the functional layer and the surface film can be significantly reduced or prevented. Consequently, multiple reflection interference in the surface film can be further significantly reduced or prevented.

In the aforementioned solid-state photodetector according to this aspect, the functional layer preferably has a lens shape. According to this configuration, due to the lens shape, in the plane waves, the traveling direction and the wave front shape of the wave front incident on the surface of the functional layer, reflected by the light receiving surface after being incident on the functional layer, and further reflected by the surface of the functional layer are not concurrently aligned or matched with the traveling direction and the wave front shape of the wave front incident on the surface of the functional layer.

In this case, the functional layer having the lens shape preferably has a function of condensing, on the light receiving surface, parallel luminous fluxes incident on the functional layer. According to this configuration, the functional layer is provided such that the photoelectric converters can receive incident light with a smaller area, a dark current generated from the photoelectric converters (photodiodes) can be reduced, and a solid-state photodetector with higher performance can be provided.

In the aforementioned solid-state photodetector in which the functional layer has the lens shape, the functional layer preferably has a shape forming a single lens. According to this configuration, the functional layer having the shape forming a single lens can be easily formed.

In the aforementioned solid-state photodetector in which the functional layer has the lens shape, the functional layer preferably has a shape forming a plurality of lenses. According to this configuration, the thickness of the functional layer can be reduced, and a thinner solid-state photodetector can be provided.

Furthermore, each of the functional layer and the photoelectric converters may have a repeated structure, and the repeated structure of the functional layer and the repeated structure of the photoelectric converters may be unaligned or unmatched with each other. According to this configuration, it is easy to form the functional layer as compared with the case in which the repeated structure of the functional layer and the repeated structure of the photoelectric converters are aligned or matched with each other.

In the aforementioned solid-state photodetector according to this aspect, the surface film and the functional layer are preferably integrally formed with each other. According to this configuration, the surface film and the functional layer can be manufactured in the same process, and thus the manufacturing process of the solid-state photodetector can be simplified.

The aforementioned solid-state photodetector according to this aspect, the functional layer is preferably preformed to prevent either the traveling directions or the wave front shapes of the first wave front, the second wave front, and the third wave front from being aligned or matched with each other by preventing mutual interference between the first wave front, the second wave front, and the third wave front. The first wave front of the plane waves of the light is incident on the functional layer and then transmits from the light receiving surface into the photoelectric converters. The second wave front of the plane waves of the light is incident on the functional layer, then is reflected by the light receiving surface to generate no transmitting light into the photoelectric converters, then is reflected by the surface of the functional layer, and transmits into the photoelectric converters. The third wave front of the plane waves of the light is incident on the functional layer, then is reflected by the refractive index interface that is present in the functional layer and the surface film before the second wave front is generated, and then transmits into the photoelectric converters. According to this configuration, multiple reflection interference can be easily significantly reduced or prevented simply by disposing the preformed functional layer on the surface film.

In this case, the solid-state photodetector may further include a bonding layer disposed between the functional layer and the surface film, the bonding layer being configured to bond, onto the surface film, the functional layer that has been preformed. According to this configuration, the preformed functional layer can be easily disposed on the surface of the surface film.

The aforementioned solid-state photodetector including the bonding layer may further include a thick film having a thickness larger than a thickness of the surface film, the thick film being disposed between the bonding layer and the surface film. According to this configuration, even when the refractive index of the functional layer and the refractive index of the surface film are significantly different from each other, multiple reflection interference can be significantly reduced or prevented.

The aforementioned solid-state photodetector including the thick film may include at least one of a bonding layer disposed between the surface film and the thick film, the bonding layer being configured to bond the surface film onto the thick film, and a bonding layer disposed between the functional layer and the thick film, the bonding layer being configured to bond the functional layer onto the thick film. According to this configuration, the surface film and the thick film (the functional layer and the thick film) can be easily bonded onto each other.

In this case, the bonding layer may be disposed both between the surface film and the thick film and between the functional layer and the thick film. According to this configuration, both the bonding of the surface film and the thick film and the bonding of the functional layer and the thick film can be easily performed.

In the aforementioned solid-state photodetector including the bonding layer, the functional layer may have a non-flat surface that faces the bonding layer disposed between the functional layer and the surface film. According to this configuration, the light receiving surface and the bonded surface of the functional layer that faces the bonding layer do not function as parallel planes, and thus the occurrence of multiple reflection interference can be significantly reduced or prevented.

### Effect of the Invention

According to the present invention, as described above, it is possible to significantly reduce or prevent light interference in the surface film that protects the light receiving surface.

### Brief Description of the Drawings

FIG. 1 is a sectional view of a solid-state photodetector according to a first embodiment.
FIG. 2 is a plan view of the solid-state photodetector (photoelectric converter) according to a first embodiment.
FIG. 3 is a diagram illustrating the relationship between wavelength and transmittance.
FIG. 4 is another diagram illustrating the relationship between wavelength and transmittance.
FIG. 5 is a diagram illustrating the relationship between amplitude reflectance and transmittance change rate.
FIG. 6 is a diagram illustrating light interference in a surface film of a solid-state photodetector having the same configuration as the conventional one.
FIG. 7 is a diagram illustrating the relationship between wavelength and transmittance.
FIG. 8 is a diagram illustrating light interference in a surface film of the solid-state photodetector according to the first embodiment.
FIG. 9 is another diagram illustrating light interference in the surface film of the solid-state photodetector according to the first embodiment.
FIG. 10 is a still another diagram illustrating light interference in the surface film of the solid-state photodetector according to the first embodiment.
FIG. 11 is a sectional view of a solid-state photodetector according to a second embodiment.
FIG. 12 is a plan view of a solid-state photodetector according to a third embodiment.
FIG. 13 is a plan view of a solid-state photodetector according to a modified example of the third embodiment.
FIG. 14 is a sectional view of a solid-state photodetector according to a fourth embodiment.
FIG. 15 is a sectional view of a solid-state photodetector according to a modified example of the fourth embodiment.
FIG. 16 is a diagram illustrating the effect of a functional layer of the solid-state photodetector according to the fourth embodiment.
FIG. 17 is another diagram illustrating the effect of the functional layer of the solid-state photodetector according to the fourth embodiment.
FIG. 18 is still another diagram illustrating the effect of the functional layer of the solid-state photodetector according to the fourth embodiment.
FIG. 19 is a sectional view of a solid-state photodetector according to another modified example of the fourth embodiment.
FIG. 20 is a sectional view of a solid-state photodetector according to a first modified example.
FIG. 21 is a sectional view of a solid-state photodetector according to a second modified example. Modes for Carrying Out the Invention

Embodiments embodying the present invention are hereinafter described on the basis of the drawings.

### First Embodiment

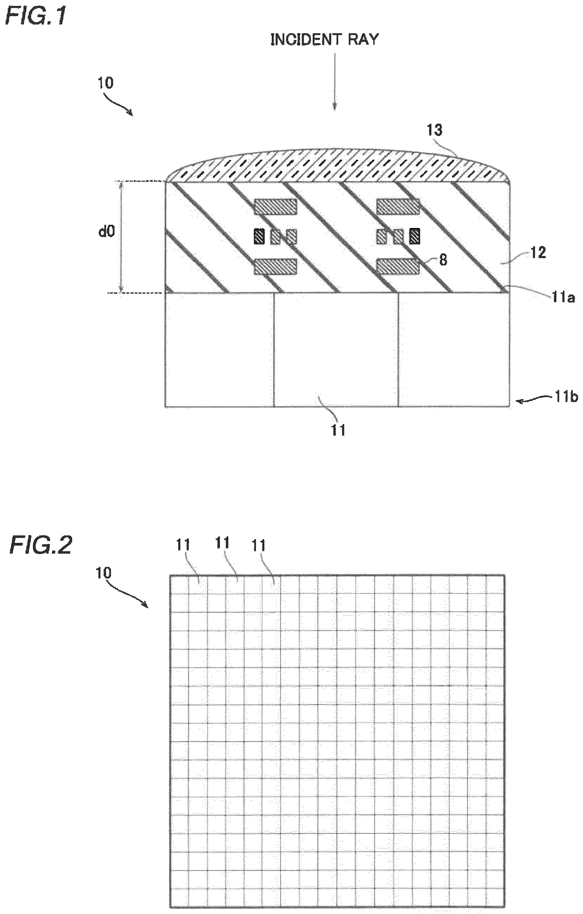

The configuration of a solid-state photodetector 10 according to a first embodiment of the present invention is now described with reference to FIGS. 1 to 10.

### (Configuration of Solid-State Photodetector)

The solid-state photo detector 10 includes a complementary metal oxide semiconductor (CMOS) sensor and a charge coupled device (CCD) sensor, both of which include photoelectric converters 11 (photodiodes), for example. In the first embodiment, the solid-state photodetector 10 is of a front surface incidence type in which light is incident from the side on which a wiring pattern 8 is provided.

As shown in FIG. 1, the front surface incidence type solid-state photodetector 10 includes the photoelectric converters 11. As shown in FIG. 2, a plurality of photoelectric converters 11 are provided. The plurality of photoelectric converters 11 are arranged in a matrix in a plan view (as viewed from the light receiving surface 11a side).

As shown in FIG. 1, the photoelectric converters 11 each have a light receiving surface 11a. The photoelectric converters 11 are configured to output signals in accordance with the intensity of light incident on the photoelectric converters 11 from the light receiving surfaces 11a. The photoelectric converters 11 are photodiodes, for example. The photodiodes are each configured to generate a charge due to light irradiation to a PN junction included in a semiconductor substrate 11b.

A surface film 12 arranged for protecting the light receiving surfaces 11a is provided on the light receiving surface 11a. The surface film 12 is made of a material such as a silicon oxide, a silicon nitride, or sapphire, for example. In the surface film 12, the wiring pattern 8 is formed. The thickness d0 of the surface film 12 is substantially constant (flat).

In the first embodiment, a functional layer 13 is provided on a surface (a surface on the opposite side to the photoelectric converter 11 side) of the surface film 12. The functional layer 13 is configured to prevent either the traveling directions or the wave front shapes of a first wave front, a second wave front, and a third wave front from being aligned or matched with each other by preventing mutual interference between the first wave front, the second wave front, and the third wave front. The first wave front of plane waves of light is incident on the functional layer 13 and then transmits from the light receiving surface 11a into the photoelectric converters 11. The second wave front of the plane waves of the light is incident on the functional layer 13, then is reflected by the light receiving surface 11a to generate no transmitting light into the photoelectric converters 11, then is reflected by a surface of the functional layer 13, and transmits into the photoelectric converters 11. The third wave front of the plane waves of the light is incident on the functional layer 13, then is reflected by a refractive index interface that is present in the functional layer 13 and the surface film 12 before the second wave front is generated, and then transmits into the photoelectric converters 11. Details of the function of the functional layer 13 are described below.

In the first embodiment, the functional layer 13 has a lens shape. Specifically, the functional layer 13 has a convex lens shape that protrudes to the light incident side. The functional layer 13 having a shape including one convex lens corresponds to the plurality of photoelectric converters 11.

In the first embodiment, the refractive index of the functional layer 13 and the refractive index of the surface film 12 are substantially equal to each other. Specifically, the functional layer 13 is made of the same material (a material such as a silicon oxide, a silicon nitride, or sapphire) as that of the surface film 12. The material of the functional layer 13 and the material of the surface film 12 may be different from each other as long as the refractive indexes are substantially equal to each other.

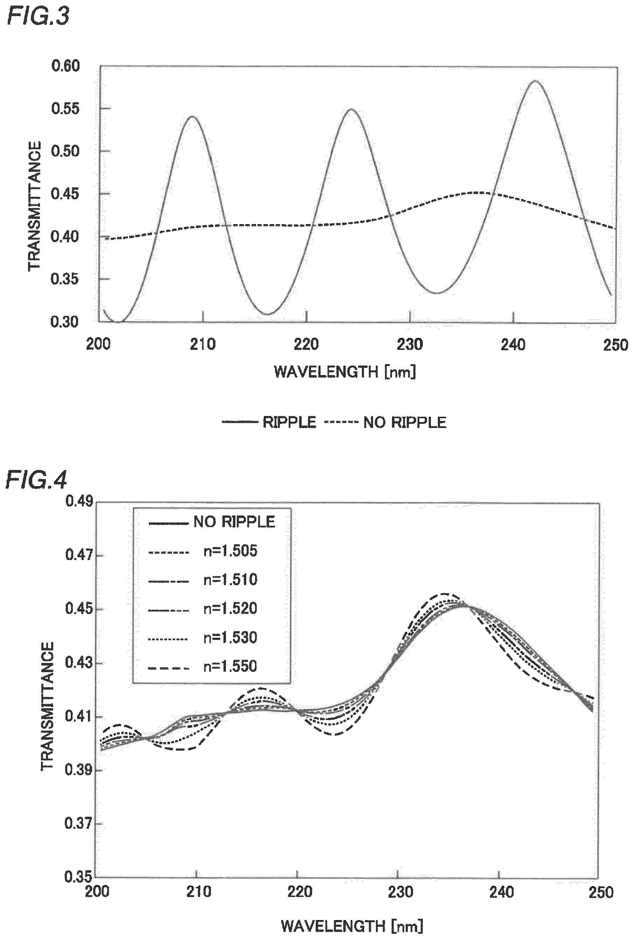

Referring to FIGS. 3 to 5, a difference between the refractive index of the functional layer 13 and the refractive index of the surface film 12 at which there is no need to consider a refractive index boundary effectively is quantitatively shown. When the refractive index is significantly different even when the functional layer 13 is stacked on the surface film 12, multiple reflection interference occurs in the surface film 12, and interference ripples are generated, as shown by a solid line (ripples) plot in FIG. 3. On the other hand, when the refractive index is sufficiently close, multiple reflection interference does not occur in the surface film 12, and interference ripples are not generated, as shown by a broken line (NO RIPPLE) in FIG. 3.

FIG. 4 is a graph on which transmittances calculated in 1 nm steps when the functional layer 13 having a thickness of 10 mm is provided on the surface film 12 having a thickness d of 1 um, and the refractive index of the functional layer 13 is changed to 1.505, 1.510, 1.520, 1.530, 1.550, and the same (1.500: "NO RIPPLE" data) as that of the surface film 12 are plotted. In order to confirm only the interference ripples generated in the surface film 12, calculation is performed under the condition that makes the thickness of the functional layer 13 sufficiently larger than the thickness of the surface film 12, and makes interference ripples due to multiple reflection interference occurring in the functional layer 13 or multiple reflection interference occurring in the surface film 12 and the functional layer 13 small (negligible) enough for ticks. From FIG. 4, it has been confirmed that the influence of the interference ripples decreases as the refractive index of the functional layer 13 is closer to the refractive index of the surface film 12.

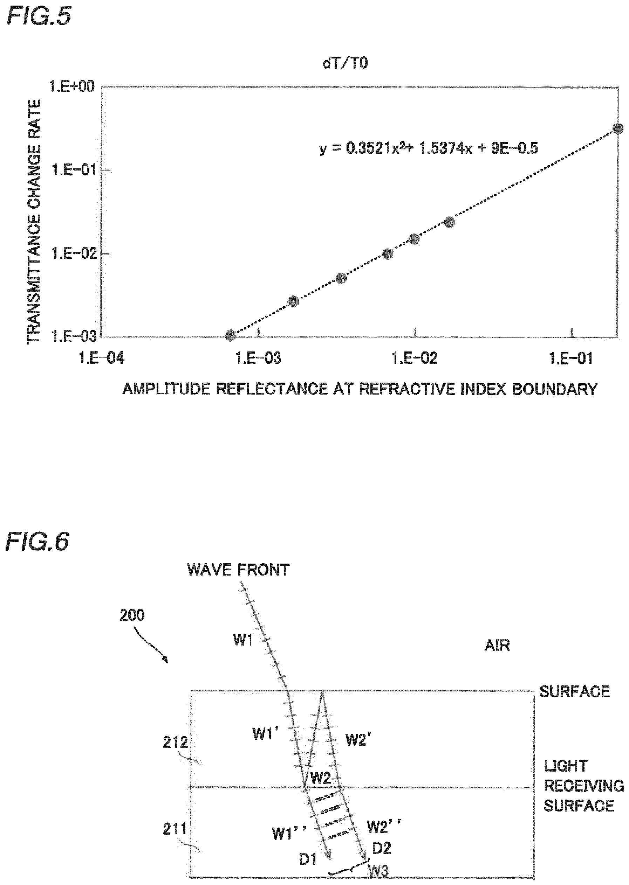

FIG. 5 is a diagram on which focusing on a peak at a wavelength of 224 nm in the graph of FIG. 4, changes in transmittance at the wavelength are plotted with respect to amplitude reflectances. The amplitude reflectance is determined by the refractive index of the surface film 12 and the refractive index of the functional layer 13, and thus the refractive index change of the functional layer 13 and the amplitude reflectance have a one-to-one relationship. The vertical axis in FIG. 5 represents the transmittance change rate (change rate with respect to the transmittance in the case of NO RIPPLE). The plot of FIG. 5 shows, from the left, the transmittance change rates in the case of the functional layer having a refractive index of 1.502, the functional layer having a refractive index of 1.505, the functional layer having a refractive index of 1.510, the functional layer having a refractive index of 1.520, the functional layer having a refractive index of 1.530, 1.550, and no functional layer 13. When this plot was approximated by a quadratic curve to obtain an amplitude reflectance in the case of 1% of the transmittance change rate in the case of no functional layer 13, the value was about 0.002. That is, when the amplitude reflectance at an interface between the functional layer 13 and the surface film 12 is 0.002 or less, the interface between the functional layer 13 and the surface film 12 can be regarded as a refractive index interface at which multiple reflection interference hardly occurs.

The functional layer 13 is formed by forming a layer (not shown), from which the functional layer 13 derives, on the surface of the surface film 12 and thereafter etching the layer from which the functional layer 13 derives, for example. Alternatively, the preformed functional layer 13 may be bonded onto the surface of the surface film 12.

### (Description of Function of Functional Layer)

The function of the functional layer 13 is now described with reference to FIGS. 6 to 10.

As shown in FIG. 6, in a solid-state photodetector 200 not provided with a functional layer 13, i.e., having the same configuration as that of the conventional one, a portion of plane waves of light (monochromatic light) incident on a surface film 212 is reflected by the surface (at a boundary with an air layer) of the surface film 212. A portion of lightwaves incident on the surface film 212 transmits into the surface film 212. In addition, the portion of the lightwaves that has transmitted into the surface film 212 is reflected at a boundary between the surface film 212 and a photoelectric converter 211. Furthermore, the portion of the lightwaves that has transmitted into the surface film 212 transmits into the photoelectric converter 211 (wave front W1").

The lightwave reflected at the boundary between the surface film 212 and the photoelectric converter 211 is reflected at the boundary between the air layer and the surface film 212, travels toward the photoelectric converter 211 via the surface film 212 again, and transmits into the photoelectric converter 211 (wave front W2"). All the incidence boundaries and the reflection boundaries up to this point are flat and parallel to each other, and thus the traveling directions of the wave front W1" and the wave front W2" are the same, and both are plane waves. Therefore, the wave front W1" and the wave front W2" interfere with each other (strengthen or weaken each other).

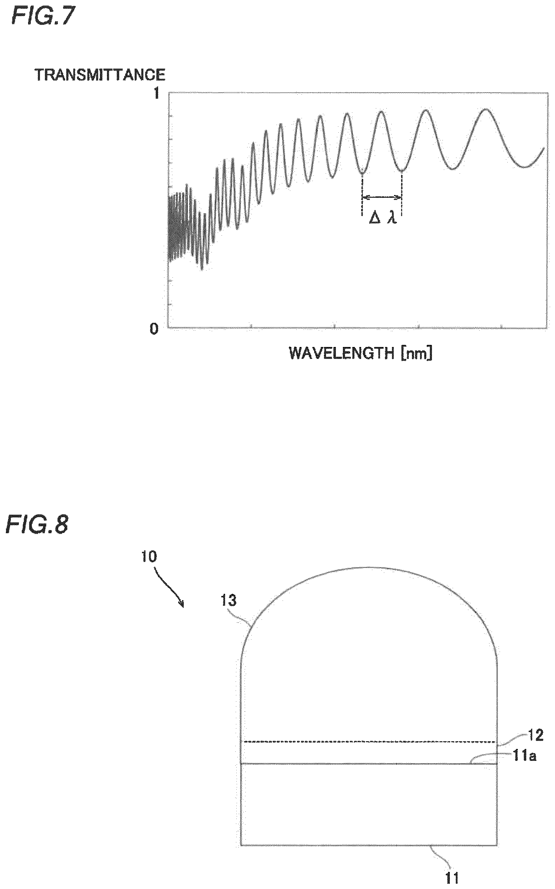

Light interference of the surface film (silicon oxide (SiO₂) film) formed on a semiconductor substrate (silicon (Si) substrate) is now described with reference to FIG. 7. In FIG. 7, the horizontal axis represents the wavelength of light, and the vertical axis represents the transmittance of the SiO₂ film with respect to light that passes from an air layer to the Si substrate.

When there is light interference (multiple reflection interference), the transmittance is violently vibrated (rippled) like a vibration waveform. Therefore, the intensity of light that reaches the photoelectric converter 211 fluctuates, and thus it becomes difficult to stabilize a signal output from the photoelectric converter 211.

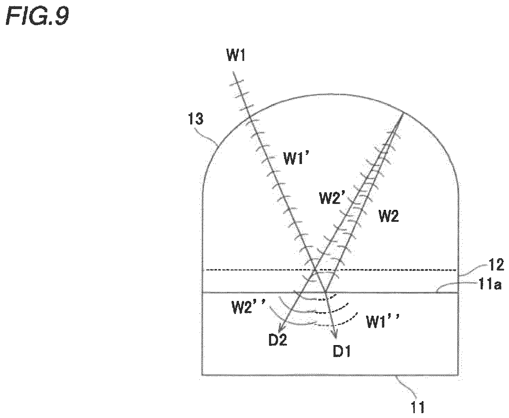

Referring to FIGS. 8 and 9, light interference is now described for the case in which a functional layer 13 is provided on a surface of a surface film 12 as in the solid-state photodetector 10 according to the first embodiment. FIGS. 8 and 9 show the state of light reflection and refraction occurring when the refractive index of the surface film 12 and the refractive index of the functional layer 13 are equal to each other.

As shown in FIG. 9, a wave front (planar lightwave) W1 obliquely incident on the functional layer 13 (lens) is refracted on the surface of the functional layer 13 while being converted to a spherical wave front, is reflected by a light receiving surface 11a, is reflected again by the surface of the functional layer 13, and travels to the light receiving surface 11a again. Furthermore, a portion thereof is reflected to become a light wave front W2, and the remainder transmits into a photoelectric converter 11 to become W1". A portion of the Light wave front W2 reflected by the light receiving surface 11a is reflected by the surface of the functional layer 13, reaches the light receiving surface 11a again, and transmits into the photoelectric converter 11 to become a light wave front W2". As can be seen from the figure, the traveling directions and the wave front shapes of the wave fronts W1" and W2" are not aligned or matched with each other. Therefore, interference does not occur.

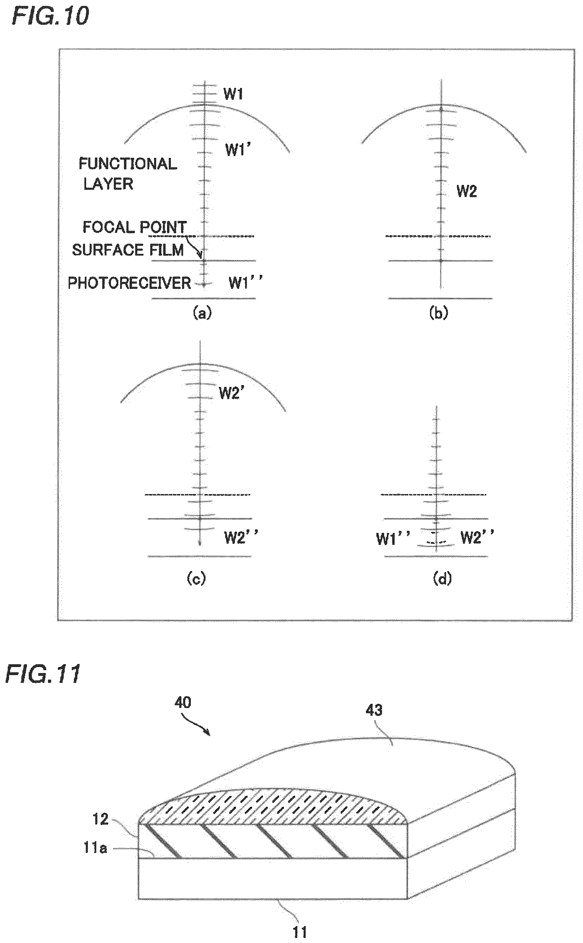

The case in which light is perpendicularly incident on the functional layer 13 is now described with reference to FIG. 10. A light wave front that is incident on the functional layer 13 and is refracted on the surface of the functional layer 13 to become substantially spherical is incident on the photoelectric converter 11 via the surface film 12. In the photoelectric converter 11, the wave front W1" is a sphere centered on the light receiving surface 11a (see FIG. 10(a)). Furthermore, a portion of the light is reflected by the light receiving surface 11a to form a wave front W2 (see FIG. 10 (b)). Thereafter, the wave front W2 is reflected again to the photoelectric converter 11 side at an interface between the functional layer 13 and an air layer (wave front W2') (see FIG. 10 (c)). When the focal point of the functional layer 13 as a lens is in the vicinity of the light receiving surface 11a in view of the light retroreflectivity, the curvatures of the wave front W1' and the wave front W2 are substantially equal to each other, whereas the curvature of the lens-shaped functional layer 13 is different from the curvature of the reaching reflected wave front W2'. Therefore, the curvature of the light wave front W2' reflected again by the functional layer 13 is different from that of the incident wave front W1'. Thus, after these two wave fronts pass through the same plane boundary (11a), the curvatures of the wave fronts W1" and W2" are also different from each other (see FIG. 10 (d)).

The phenomenon that the curvatures of the wave fronts W1" and W2" are also different from each other does not relate to whether or not the focal point of the functional layer 13 is in the vicinity of the light receiving surface 11a. In order for W1" and W2" to have the same curvature, W1' and W2' need to have the same curvature. The wave front W2 reflected by the surface of the functional layer is W2', and thus in order for the curvatures of these wave fronts to match each other, the curvature of the functional layer 13 is required to be equal to those of the wave fronts W1' and W2' on the surface of the functional layer 13. This condition is allowing the normal of the wave front W1' to coincide with the center of curvature of the functional layer 13. That is, this indicates that the refraction angle in the functional layer 13 should be 0 degrees at an arbitrary point on the surface of the functional layer 13. According to Snell's law, the incident angle of the wave front W1 is also 0 degrees at the arbitrary point on the surface of the functional layer 13, which means that the surface curvature of the functional layer 13 matches the curvature of W1. That is, W1 is required not to be a plane wave, and thus the curvatures of the wave fronts W1" and W2" do not match each other as long as the plane wave is incident. That is, it indicates that interference does not occur.

Thus, the functional layer 13 is added such that multiple reflection interference in the surface film 12 does not occur in principle. Also in the functional layer 13, multiple reflection interference does not occur similarly. Therefore, there are no ripples of the transmittance of the surface film 12 and the functional layer 13 with respect to the wavelength of incident light that reaches the photoelectric converter 11, and the energy of light received by the photoelectric converter 11 becomes less likely to change. That is, it becomes possible to stabilize the sensitivity of the solid-state photodetector 10. In the above description, it is assumed that a plane wave incident on the surface of the functional layer 13 having a lens function due to its spherical shape is refracted on the surface of the functional layer 13 to become a spherical wave. Strictly speaking, the wave front after passing through the functional layer 13 is not perfectly spherical, but is described as a "spherical wave front" in order to simplify the explanation. Even when it is non-spherical and arbitrarily curved, similarly, the above two wave fronts W1" and W2" do not match each other.

### Advantages of First Embodiment

According to the first embodiment of the present invention, the following advantages are obtained.

According to the first embodiment, as described above, the solid-state photodetector 10 includes the functional layer 13 configured to prevent either the traveling directions or the wave front shapes of the wave fronts from being aligned or matched with each other. One of the wave fronts of the plane waves of the light is incident on the surface of the surface film 12, then is reflected by the refractive index interface that is present in the functional layer 13 and the surface film 12, and then transmits into the photoelectric converters 11. The remainder of the wave fronts of the plane waves of the light is incident on the surface of the surface film 12, then enters the functional layer, and then transmits into the photoelectric converters 11 without being reflected at the refractive index interface. Accordingly, mutual strengthening (or weakening) of multiple reflected light that transmits into the photoelectric converters 11, which occurs in the surface film 12 in the conventional configuration is significantly reduced or prevented. Consequently, it is possible to significantly reduce or prevent multiple reflection interference in the surface film 12 that protects the light receiving surface 11a. Thus, instability of the sensitivity of the solid-state photodetector 10 can be significantly reduced or prevented.

According to the first embodiment, as described above, the functional layer 13 has a refractive index substantially equal to the refractive index of the surface film 12, or the functional layer 13 and the surface film 12 are made of the same material. Accordingly, light reflection at the interface between the functional layer 13 and the surface film 12 is significantly reduced or prevented. Consequently, multiple reflection interference in the surface film 12 can be almost completely prevented.

According to the first embodiment, as described above, the functional layer 13 has a convex lens shape. Accordingly, the functional layer 13 has a function of condensing, on the light receiving surface 11a, parallel luminous fluxes incident on the functional layer 13, and thus light can be efficiently focused into the lens center. Furthermore, due to the lens shape, in the plane waves, the traveling direction and the wave front shape of the wave front incident on the surface of the functional layer 13, reflected by the light receiving surface 11a after being incident on the functional layer 13, and further reflected by the surface of the functional layer 13 are not concurrently aligned or matched with the traveling direction and the wave front shape of the wave front incident on the surface of the functional layer 13.

According to the first embodiment, as described above, the functional layer 13 having a lens shape has a function of condensing, on the light receiving surface 11a, the parallel luminous fluxes incident on the functional layer 13. Accordingly, the functional layer 13 is provided such that the photoelectric converters 11 can receive incident light with a smaller area, a dark current generated from the photoelectric converters 11 (photodiodes) can be reduced, and a solid-state photodetector 10 with higher performance can be provided.

### Second Embodiment

A second embodiment is now described with reference to FIG. 11. In this second embodiment, a functional layer 43 has a cylindrical lens shape.

As shown in FIG. 11, in a solid-state photodetector 40 according to the second embodiment, the functional layer 43 has a cylindrical lens shape that causes the wave front of a plane wave incident on the functional layer 43 to have a curvature in a uniaxial direction. Specifically, the functional layer 43 has a cylindrical lens shape that protrudes toward the light incident side. More specifically, the focal point of the cylindrical lens exists in the vicinity of a light receiving surface 11a. In addition, the functional layer 43 is formed by forming a layer (not shown) from which the functional layer 43 derives and thereafter cutting out the layer from which the functional layer 43 derives, for example. Alternatively, the preformed functional layer 43 may be bonded onto a surface of a surface film 12.

The advantages of the second embodiment are similar to those of the first embodiment.

### Third Embodiment

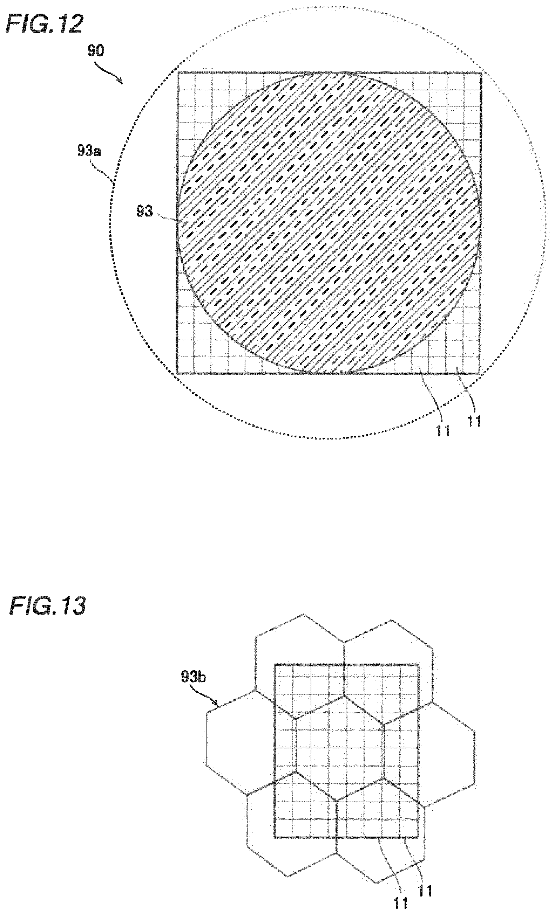

A third embodiment is now described with reference to FIG. 12. In this third embodiment, a functional layer 93 having a single shape (a shape forming a single lens) is provided across a plurality of photoelectric converters 11.

As shown in FIG. 12, in a solid-state photodetector 90 according to the third embodiment, the functional layer 93 having a single shape is provided across the plurality of photoelectric converters 11 arranged in a matrix. Specifically, the functional layer 93 has a substantially circular shape in a plan view, and is provided to partially cover the plurality of photoelectric converters 11 arranged in a matrix. The functional layer 93 has a convex lens shape, for example. Alternatively, as in a functional layer 93a indicated by a broken line in FIG. 12, the functional layer 93a may be provided to entirely cover the plurality of photoelectric converters 11 arranged in a matrix.

Alternatively, as in a functional layer 93b shown in FIG. 13, the functional layer 93b may have a shape forming a plurality of hexagonal lenses in a plan view. Thus, the thickness of the functional layer 93b can be reduced. The functional layer 93b and photoelectric converters 11 each have a repeated structure, and the repeated structure of the functional layer 93b and the repeated structure of the photoelectric converters 11 are unaligned or unmatched with each other. That is, the hexagon pitch of the functional layer 93b is different from a pitch between the photoelectric converters 11. Thus, it is easy to form the functional layer 93b as compared with the case in which the repeated structure of the functional layer 93b and the repeated structure of the photoelectric converters 11 are aligned or matched with each other. In addition, the functional layer 93b may have a shape other than a hexagon (such as a tetragon) in the plan view.

### Advantages of Third Embodiment

According to the third embodiment, the following advantages are obtained.

According to the third embodiment, as described above, the functional layer 93 having a single shape is provided across the plurality of photoelectric converters 11. Accordingly, the size of the functional layer 93 is increased as compared with the case in which the functional layer 93 is formed for each photoelectric converter 11, and thus the functional layer 93 can be easily formed.

### Fourth Embodiment

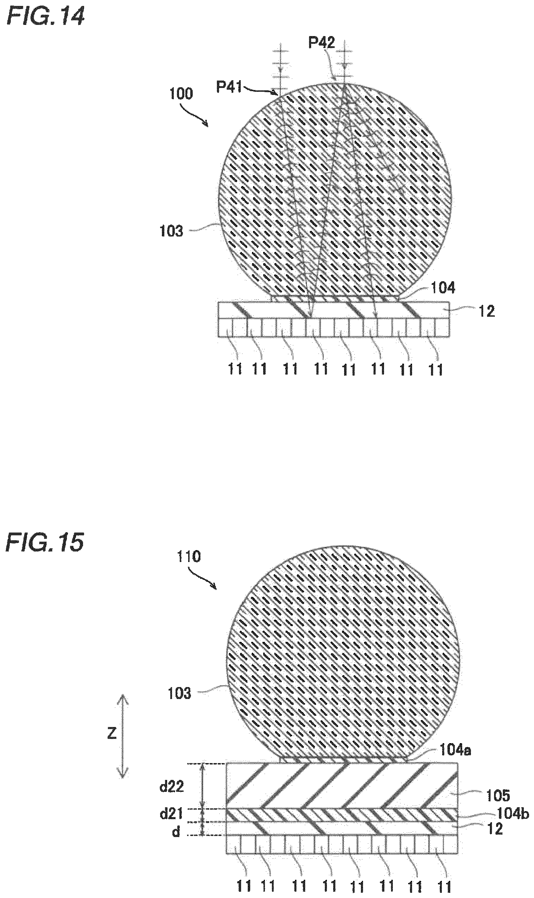

A fourth embodiment is now described with reference to FIG. 14. In this fourth embodiment, a bonding layer 104 configured to bond a functional layer 103 onto a surface film 12 is provided.

As shown in FIG. 14, the functional layer 103 of a solid-state photodetector 100 according to the fourth embodiment is preformed to prevent the traveling directions and the wave front shapes of a wave front of plane waves of incident light, the wave front being incident on a surface of the functional layer 103, being reflected by a light receiving surface 11a after being incident on the functional layer 103, and further being reflected by the surface of the functional layer 103, and a wave front of the plane waves of the incident light, the wave front being incident on the surface of the functional layer 103, from being concurrently aligned or matched with each other. That is, the functional layer 103 is preformed as a separate component by a process different from a manufacturing process (semiconductor manufacturing process) of photoelectric converters 11 and the surface film 12. Then, the preformed functional layer 103 is bonded onto a surface of the surface film 12 by the bonding layer 104. The refractive index of the bonding layer 104 and the refractive index of the surface film 12 are substantially equal to each other, and the amplitude reflectance at this interface is less than 0.002. The functional layer 103 is provided across a plurality of photoelectric converters 11. The functional layer 103 has a lens shape.

The functional layer 103 and the surface film 12 are each made of a silicon oxide, a silicon nitride, sapphire or the like. In addition, the bonding layer 104 is made of a material that transmits light having a specific wavelength. The functional layer 103 may alternatively be bonded onto the surface of the surface film 12 by a spin-on glass (SOG) method, for example.

In bonding between the functional layer 103 and the surface film 12, the bonding layer 104 may not be used. That is, the functional layer 103 and the surface film 12 may alternatively be directly bonded onto each other by a method such as optical contact.

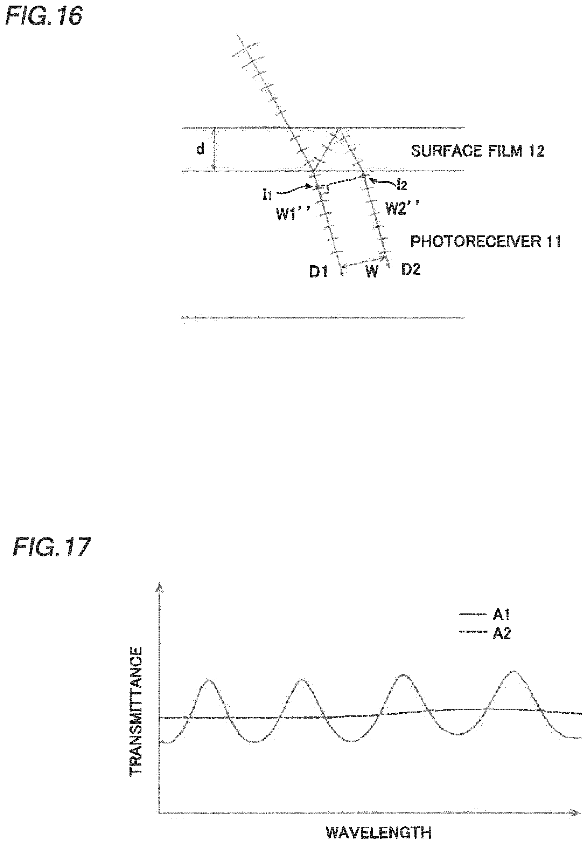

When the refractive index of the functional layer 103 needs to be sufficiently larger than the refractive index of the above silicon oxide, silicon nitride, sapphire, or the like in order to ensure the desired light collection performance, a material having a higher refractive index, such as alumina, may be used. In this case, the refractive index of the functional layer 103 and the refractive index of the surface film 12 are significantly different from each other, and thus multiple reflection interference occurs in the surface film 12. In this case, as in a solid-state photodetector 110 according to a modified example of the fourth embodiment shown in FIG. 15, a bonding layer 104a is disposed between a functional layer 103 and a thick film 105, a bonding layer 104b having a refractive index substantially equal to the refractive index of a surface film 12 is disposed on the surface film 12, and the thick film 105 having a refractive index substantially equal to that of the bonding layer 104b and a thickness d22 considerably larger than the thickness d of the surface film 12 in a Z direction is provided such that the shape of an incident wave front is greatly changed, and no interference occurs. The reason is described below with reference to FIGS. 16, 17, and 18.

FIG. 16 shows the principle that interference occurs when in the solid-state photodetector 100 shown in FIG. 14, the functional layer 103 has a lens shape (spherical shape) and its refractive index is significantly different from the refractive index of the surface film 12. Although not shown in FIG. 16, the bonding layer 104 and the functional layer 103 are disposed on the surface film 12. Here, the refractive indexes of the surface film 12 and the bonding layer 104 are described as being substantially equal to each other.

When plane wave light is incident on the functional layer 103, its wave front is converted from a plane to a spherical wave. The light that propagates inside the functional layer 103 in the state of a spherical wave is refracted at an interface with the bonding layer 104. At this time, while the wave front is deformed by the interface, its radius of curvature is only changed, and it remains that the wave front is a spherical wave. This holds true for both of the following refraction and reflection.

Thereafter, as shown in FIG. 16, a portion of the spherical wave that has propagated through the bonding layer 104 and the surface film 12 is refracted at an interface between the surface film 12 and the photoelectric converters 11 to form a wave front W1", and a portion is reflected and thereafter further reflected at the interface between the bonding layer 104 and the functional layer 13. Then, it is incident again on the photoelectric converters 11, and a portion thereof is refracted and transmits into the photoelectric converters 11 to form a wave front W2".

Assuming that the radius of curvature of the wave front at a point I₁ (the position of a black circle point slightly advanced from an intersection of the interface between the surface film 12 and the photoelectric converters 11 and the light beam) of the wave front W1" is R1, the radius of curvature R2 of the wave front W2" at a point I₂ is about R1 - 2d. The spherical wave has the property of converging to a certain point, and thus the radius of curvature of the wave front is equal to a distance to the convergence point. A distance (optical path length) traveled by the wave front W2" is longer than that traveled by the wave front W1", and thus the radius of curvature of the wave front W2" becomes smaller due to the longer travel distance of the wave front W2".

The radii of curvature of the wave fronts W1" and W2" are R1 and R1 - 2d, respectively, while the thickness d of the surface film 12 and the bonding layer 104 is on the order of µm at most and sufficiently small relative to the radius of curvature R1. Therefore, it can be regarded that R1 ≒ R2. Furthermore, a distance W between the two wave fronts is approximately the same as d, and thus it is on approximately the same order as the target wavelength. Therefore, the wave front W1" and the wave front W2" having radii of curvature substantially equal to each other travel in parallel at the near distance W, and thus interference occurs (see a solid line A1 in FIG. 17).

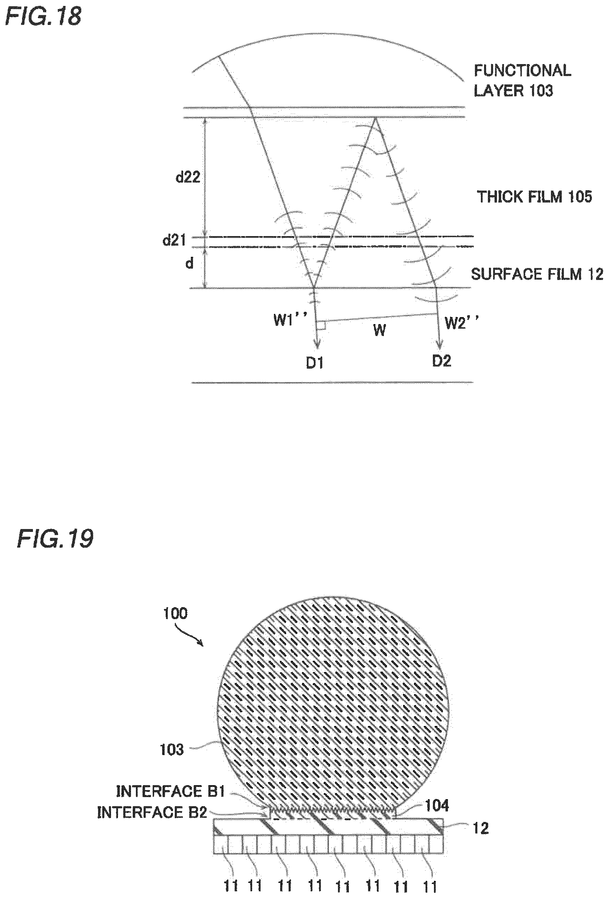

FIG. 18 shows the principle that interference does not occur when the thick film 105 is disposed between the functional layer 103 and the surface film 12 via the bonding layers 104a and 104b, respectively, as shown in FIG. 15. The relationship between the wave front W1" and the wave front W2" is substantially the same as that in FIG. 16, and the difference is that the thickness of a region in which multiple reflection occurs is increased from the thickness d of only the surface film 12 in FIG. 14 to a thickness (d + d21 + d22) obtained by adding the thickness d of the surface film 12, the thickness d21 of the bonding layer 104b, and the thickness d22 of the thick film 105. In this case, the radius of curvature R2 of the wave front W2" is R2 ≒ R1 - 2 (d + d21 + d22), and (d + d21 + d22) has a size that cannot be ignored with respect to R1. Thus, R1 ≠ R2. The distance W between the wave front W1" and the wave front W2" also depends on (d + d21 + d22), and thus it increases. Therefore, the wave front W1" and the wave front W2" having significantly different radii of curvature travel parallel to each other and away from each other, and thus interference does not occur (see a dotted line A2 in FIG. 17).

Also in the modified example of the fourth embodiment shown in FIG. 15, the bonding layers 104a and 104b may not be interposed as a method for bonding the functional layer 103 and the surface film 12 onto the thick film 105. As in the fourth embodiment, both or any one of the functional layer 103 and the surface film 12 may be directly bonded onto the thick film 105 by a method such as optical contact.

When the refractive index of the functional layer 103 is higher than the refractive index of the surface film 12, in order to significantly reduce or prevent multiple reflection interference in the surface film 12, a surface of the functional layer 103 in contact with the bonding layer 104 may be formed as a non-flat surface (may not be flat) (the average exhibits a plane parallel to the surface film 12, and the non-flat surface is a surface different in orientation from the average plane), as shown in FIG. 19, instead of providing the thick film 105. More specifically, the non-flat surface may be formed of a rough surface (which functions as a scattering surface at the wavelength received by this photodetector).

The principle that the surface of the functional layer 103 in contact with the bonding layer 104 is a non-flat surface such that multiple reflection interference is significantly reduced or prevented is based on that the surface of the functional layer 103 in contact with the bonding layer 104 and the surface of the surface film 12 in contact with the light receiving surface 11a do not become parallel planes. The refractive index of the functional layer 103 is different from the refractive index of the bonding layer 104, and thus an interface B1 between the functional layer 103 and the bonding layer 104 functions as a refractive index boundary. On the other hand, the refractive indexes of the bonding layer 104 and the surface film 12 are substantially equal to each other, and thus an interface B2 between the bonding layer 104 and the surface film 12 does not function as a refractive index boundary. Therefore, multiple reflection interference does not occur between the surface of the surface film 12 in contact with the light receiving surface 11a and the interface B2 between the bonding layer 104 and the surface film 12.

### Advantages of Fourth Embodiment

According to the fourth embodiment, the following advantages are obtained.

According to the fourth embodiment, as described above, the functional layer 103 is preformed to prevent the traveling directions and the wave front shapes of the wave front of the plane waves of the incident light, the wave front being incident on the surface of the functional layer 103, being reflected by the light receiving surface 11a after being incident on the functional layer 103, and further being reflected by the surface of the functional layer 103, and the wave front of the plane waves of the incident light, the wave front being incident on the surface of the functional layer 103, from being concurrently aligned or matched with each other. Accordingly, the conventional solid-state photodetector in which multiple reflection interference occurs can be configured as the solid-state photodetector 100 in which multiple reflection interference is significantly reduced or prevented simply by disposing the preformed functional layer 103 on the surface of the surface film 12.

According to the modified example of the fourth embodiment, as described above, the thick film 105 is disposed between the functional layer 103 and the surface film 12. Alternatively, the bonding layer 104 is disposed between the functional layer 103 and the surface film 12, and the surface of the functional layer 103 in contact with the bonding layer 104 is a non-flat surface. Accordingly, due to the functional layer 103, a material having a high refractive index can be used, and the light collection characteristics of the functional layer 103 can be improved while multiple reflection interference in the surface film 12 is significantly reduced or prevented.

### Modified Examples

The embodiments disclosed this time must be considered as illustrative in all points and not restrictive. The scope of the present invention is not shown by the above description of the embodiments but by the scope of claims for patent, and all modifications (modified examples) within the meaning and scope equivalent to the scope of claims for patent are further included.

For example, while the example in which the functional layer according to the present invention is applied to the front surface incidence type solid-state photodetector has been shown in each of the aforementioned first to fourth embodiments, the present invention is not limited to this. For example, the functional layer (the functional layer 13, for example) according to the present invention may be provided in a back surface incidence type solid-state photodetector in which light is incident from the side opposite to the side on which a wiring pattern is provided. In this example, the functional layer is provided on the back surface (light incident surface).

While the example in which the refractive index of the functional layer and the refractive index of the surface film are substantially equal to each other has been shown in each of the aforementioned first to third embodiments and part of the aforementioned fourth embodiment, the present invention is not limited to this. For example, the refractive index of the functional layer and the refractive index of the surface film may be different from each other to some extent.

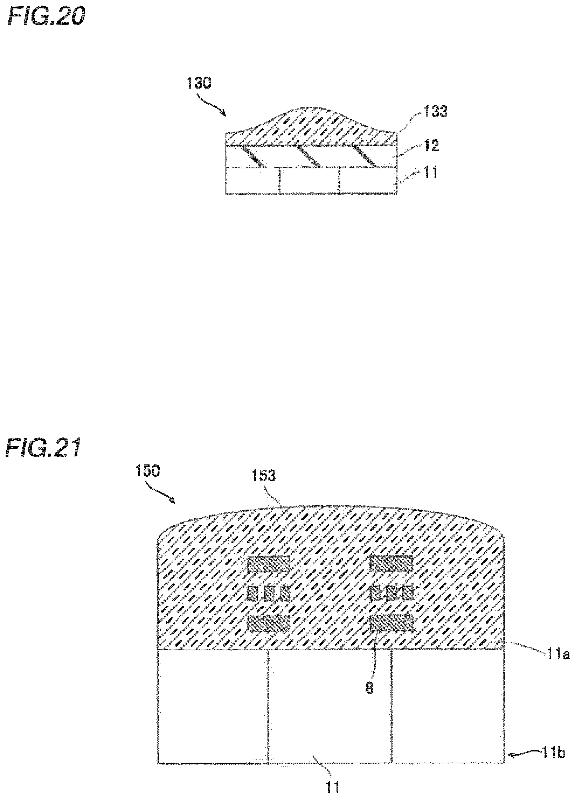

While the examples in which the functional layer has a convex lens shape and a cylindrical lens shape have respectively been shown in the aforementioned first and second embodiments, the present invention is not limited to this. For example, as in a functional layer 133 of a solid-state photodetector 130 shown in a first modified example of FIG. 20, the functional layer 133 may have an aspherical lens shape.

While the example in which the functional layer and the surface film are provided separately from each other has been shown in each of the aforementioned first to third embodiments, the present invention is not limited to this. For example, as in a solid-state photodetector 150 according to a second modified example of FIG. 21, a surface film 153 may be configured to function as a functional layer (the surface film and the functional layer may be integrally formed with each other). Thus, an interface between the surface film and the functional layer disappears, and multiple reflection interference can be further significantly reduced or prevented.

While the examples in which the functional layer is formed by etching and cutting-out have respectively been shown in the aforementioned first and second embodiments, the present invention is not limited to this. For example, the functional layer may be formed by polishing, vapor deposition, crystal growth, lithography, thermoforming, or the like.

### Description of Reference Numerals

8: wiring pattern
10, 40, 90, 100, 130, 150, 200: solid-state photodetector
11: photoelectric converter
11a: light receiving surface
12, 153: surface film
13, 43, 93, 93a, 93b, 103, 133: functional layer
104: bonding layer

## Claims

1. A solid-state photodetector comprising:
a plurality of photoelectric converters configured to output signals in accordance with an intensity of received light;
a surface film arranged for protecting the photoelectric converters; and
a functional layer provided on a surface of the surface film; wherein
the functional layer is configured to prevent either traveling directions or wave front shapes of a first wave front, a second wave front, and a third wave front from being aligned or matched with each other by preventing mutual interference between the first wave front, the second wave front, and the third wave front,
the first wave front of plane waves of light being incident on the functional layer and then transmitting from a light receiving surface into the photoelectric converters;
the second wave front of the plane waves of the light being incident on the functional layer, then being reflected by the light receiving surface to generate no transmitting light into the photoelectric converters, then being reflected by a surface of the functional layer, and transmitting into the photoelectric converters; and
the third wave front of the plane waves of the light being incident on the functional layer, then being reflected by a refractive index interface that is present in the functional layer and the surface film before the second wave front is generated, and then transmitting into the photoelectric converters.

2. The solid-state photodetector according to claim 1, wherein
the functional layer has a refractive index substantially equal to a refractive index of the surface film; or
the functional layer and the surface film are made of a same material.

3. The solid-state photodetector according to claim 1 or 2, wherein the functional layer has a lens shape.

4. The solid-state photodetector according to claim 3, wherein the functional layer has a shape forming a single lens.

5. The solid-state photodetector according to claim 3, wherein the functional layer has a shape forming a plurality of lenses.

6. The solid-state photodetector according to claim 5, wherein
each of the functional layer and the photoelectric converters has a repeated structure; and
the repeated structure of the functional layer and the repeated structure of the photoelectric converters are unaligned or unmatched with each other.

7. The solid-state photodetector according to claim 1 or 2, wherein the surface film and the functional layer are integrally formed with each other.

8. The solid-state photodetector according to claim 1 or 2, wherein
the functional layer is preformed to prevent either the traveling directions or the wave front shapes of the first wave front, the second wave front, and the third wave front from being aligned or matched with each other by preventing mutual interference between the first wave front, the second wave front, and the third wave front,
the first wave front of the plane waves of the light being incident on the functional layer and then transmitting from the light receiving surface into the photoelectric converters;
the second wave front of the plane waves of the light being incident on the functional layer, then being reflected by the light receiving surface to generate no transmitting light into the photoelectric converters, then being reflected by the surface of the functional layer, and transmitting into the photoelectric converters; and
the third wave front of the plane waves of the light being incident on the functional layer, then being reflected by the refractive index interface that is present in the functional layer and the surface film before the second wave front is generated, and then transmitting into the photoelectric converters.

9. The solid-state photodetector according to claim 8, further comprising a bonding layer disposed between the functional layer and the surface film, the bonding layer being configured to bond, onto the surface film, the functional layer that has been preformed.

10. The solid-state photodetector according to claim 8, further comprising a thick film having a thickness larger than a thickness of the surface film, the thick film being disposed between the surface film and the functional layer.

11. The solid-state photodetector according to claim 10, comprising at least one of a bonding layer disposed between the surface film and the thick film, the bonding layer being configured to bond the surface film onto the thick film, and a bonding layer disposed between the functional layer and the thick film, the bonding layer being configured to bond the functional layer onto the thick film.

12. The solid-state photodetector according to claim 11, wherein the bonding layer is disposed both between the surface film and the thick film and between the functional layer and the thick film.

13. The solid-state photodetector according to claim 9, wherein the functional layer has a non-flat surface that faces the bonding layer disposed between the functional layer and the surface film.
